# EUROPÄISCHE PATENTSCHRIFT

(11) **EP 0 976 105 B1**
(45) Veröffentlichungstag und Bekanntmachung des Hinweises auf die Patenterteilung: **11.09.2002**
(21) Anmeldenummer: 98924078.3
(22) Anmeldetag: 25.03.1998
(51) Int. Cl.: G06K 19/077

(54) **CHIPKARTE UND VERFAHREN ZUR HERSTELLUNG EINER CHIPKARTE**
CHIP CARD AND METHOD FOR PRODUCING A CHIP CARD
CARTE A PUCE ET SON PROCEDE DE FABRICATION

(30) Priorität: 18.04.1997 DE 19716342
(43) Veröffentlichungstag der Anmeldung: 02.02.2000
(73) Patentinhaber: PAV Card GmbH, 22952 Lütjensee (DE)
(72) Erfinder: WILM, Robert, D-22929 Kasseburg (DE); KISTENMACHER, Dirk, D-22952 Lütjensee (DE)
(74) Vertreter: Kruspig, Volkmar, Dipl.-Ing.
(86) Internationale Anmeldenummer: EP9801751
(87) Internationale Veröffentlichungsnummer: WO98048379

(56) Entgegenhaltungen:
- EP-A- 0 737 935
- WO-A-96/07985
- DE-A- 4 424 396
- DE-A- 4 431 606
- US-A- 5 025 550

## Beschreibung

Die Erfindung betrifft eine Chipkarte mit einem Kartenkörper zur Aufnahme eines Transponder-Halbleiterbauelementes, wobei dieses mit einer in der Karte angeordneten induktiven Signalübertragungseinrichtung in Form einer Antennenspule kontaktiert ist, sowie ein Verfahren zur Herstellung einer derartigen Chipkarte gemäß Oberbegriff der Patentansprüche 1 bzw. 4.

Es ist bekannt, bei der Herstellung einer Chipkarte, insbesondere solcher, die Mittel zur kontaktlosen Datenübertragung aufweisen, in einen Kartenkörper ein Modul einzubringen, welcher einen Halbleiterchip umfaßt.

Dieser separate Modul mit Halbleiterchip wird vorzugsweise in eine Ausnehmung im Kartenkörper eingelegt und mittels Fügen oder dergleichen mit dem Kartenkörper unter Erhalt einer entsprechenden mechanischen und elektrischen Verbindung laminiert. Beispielsweise kann eine elektrische Verbindung zwischen Modul und Kartenkörper bzw. auf dem Kartenkörper befindlichen Kontakten, die mit einer Spule zur Herstellung einer kontaktlosen Verbindung zur Umgebung hin in Kontakt stehen, dadurch zustande kommen, daß ein anisotroper leitender Klebstoff im Bereich der Anschlußstellen und/oder der Verbindungsstellen des jeweiligen Mittels für eine kontaktlose Datenübertragung aufgetragen und der Klebstoff zumindest im Bereich der Anschlußstellen so weit verdichtet oder komprimiert wird, daß eine elektrisch leitende Brücke entsteht.

Die bei der Herstellung von Chipkarten verwendeten Module greifen in der Regel auf einen Kunststoffträger zurück, auf dem der eingangs erwähnte Halbleiterchip mit Kontaktflächen versehen, angeordnet ist. Das so vorgefertigte ISO-Modul wird mit dem Kartenträger, der z.B. aus Polycarbonat bestehen kann, verbunden. Dieses Verbinden bzw. das Einsetzen des komplexen Moduls in den Kartenkörper in eine, z.B. gefräste Ausnehmung erfolgt üblicherweise unter Rückgriff auf die genannten Klebeverfahren bei Verwendung eines Heiß- oder Schmelzklebers. Die verwendeten Chipmodule sind beispielsweise Chip on Flex mit Globe Top oder Chip on Flex mit Mold Compound.

Die Chips werden nach dem Vereinzeln auf dem Modul chipkontaktiert, wobei der Modul die genannten Kontaktflächen zum Herstellen äußerer elektrischer Verbindungen aufweist. Über ein Drahtbondverfahren werden die Kontaktflächen der Chips mit den Modul-Kontaktflächen verbunden. Anschließend ist zur Vermeidung von Beschädigungen des Moduls dieser mit einer Verkapselung zu versehen.
Die Verfahrensschritte zur Herstellung des Moduls mit Halbleiterchip sind jedoch sehr zeit- und kostenintensiv, wobei durch den sandwichartigen Aufbau der so gestalteten Baugruppe bestimmte Abmessungen sowohl in lateraler als auch hinsichtlich der minimalen Dicke nicht unterschritten werden können. Da jedoch die Chipkarte bzw. der Kartenträger der Chipkarte möglichst dünn auszubilden ist, gleichzeitig aber über eine ausreichende Stabilität hinsichtlich von Biege- und anderen Belastungszyklen erfüllen soll, ergeben sich hier wesentliche Probleme hinsichtlich der gewünschten Fortentwicklung des Standes der Technik.

Aus der WO-A-9607985 ist eine gattungsgemäße Chipkarte bekannt, welche über eine Antennenspule verfügt und welche insgesamt als Laminatkörper ausgebildet ist.

Gemäß DE 44 24 396 A1 ist für die Kontaktierung zwischen einem IC-Baustein und einem Trägerelement auf die Möglichkeit verwiesen, Lötkugeln zu verwenden. Allerdings ist die derart realisierte Chipkarte kontaktbehaftet, d.h. es ist keine Antennenspule zur induktiven Datenübertragung vorgesehen.

Bei dem Verfahren zum Herstellen kleiner implantierbarer Transponderanordnungen nach US 5,025,550 wird ein Leadframe auf einem Halbleiterwafer angeordnet und danach ein Vereinzeln der Leadframe-Chips mittels Sägen vorgenommen.

Aus dem Vorgenannten ist es daher Aufgabe der Erfindung, eine Chipkarte und ein Verfahren zur Herstellung einer Chipkarte anzugeben, welche von einem Kartenträger zur Aufnahme eines Transponder-Halbleiterbauelements und in der Karte angeordneten induktiven Signalübertragungseinrichtungen ausgeht, wobei extrem dünne Bauformen mit höchster Biegesteifigkeit bei gleichzeitig geringen Kosten realisierbar sein sollen.

Die Lösung der Aufgabe der Erfindung erfolgt mit einer Chipkarte gemäß den Merkmalen des Patentanspruches 1 sowie einem Herstellungsverfahren, wie es im Patentanspruch 4 definiert ist. Die Unteransprüche stellen mindestens zweckmäßige Ausgestaltungen und Weiterbildungen dar.

Der Grundgedanke der Erfindung besteht nun darin, von einer Halbleiterbaugruppe auszugehen, die im Scheibenverband bis hin zur Kontaktierung und Verkappung fertigungsoptimal und mit minimaler Schichtdicke erstellt wird.

Dabei wird von insbesondere integrierten Speicherbausteinen ausgegangen, die im Scheiben- oder Waferverband vorliegen. Zunächst erfolgt eine rückseitige Abdünnung des Substrats mit dem Ziel der Minimierung der gesamten Dicke der später vorliegenden Baugruppe. Gegebenenfalls wird der abgedünnte Wafer bzw. das abgedünnte Substrat rückseitig mit einer temporären Versteifungsmembran versehen, so daß die Handhabung für die weiteren technologischen Schritte vereinfacht und eine erhöhte Sicherheit gegen unerwünschte Beschädigungen, z.B. Bruch des Wafers gegeben ist.

Die auf der aktiven Seite des Wafers vorhandenen Bondpads werden wenn nötig metallisiert und/oder mit Bumps versehen, so daß ein ebenfalls im Scheibenverband vorliegender Leadframeverbund aufbringbar ist.

Der Leadframeverbund weist einzelne Leadframeabschnitte für jeden Einzelchip auf. Jeder Leadframeabschnitt besitzt mindestens zwei großflächige Kontakte zum Anschluß der im Kartenträger drahtverlegten oder einlaminierten, gestanzten Antennenspule, die als induktive Signalübertragungseinrichtung dient.

Erfindungsgemäß ist die Gesamtfläche der vor der Montage in die Chipkarte vereinzelnden Chips mit Leadframe minimiert, wobei jeder der großflächigen Leadframekontakte im wesentlichen die Hälfte der maximal zur Verfügung stehenden Leadframe- oder Chipfläche einnimmt.

Konkret wird also verfahrensseitig zur Herstellung der Chipkarte zunächst von im Scheibenverband vorliegenden, Bondpads umfassenden, rückseitig abgedünnten Halbleiterbauelementen ausgegangen. Diese werden mit einer schweiß- und/oder lötfähigen Metallisierung oder Kontaktbereich bzw. im Bereich der Bondpads versehen.

Anschließend wird mit Ausnahme der vorgesehenen oder ausgewählten Kontaktbereiche eine Passivierungsschicht, z.B. eine polymere Passivierung, die auch zu Isolationszwecken dient, aufgebracht. Weiterhin wird ebenfalls im Scheibenverband ein Leadframeverbund, umfassend einzelne Leadframes, abgestellt auf die spätere Einzelchipgröße, paßgenau auf der aktiven, kontaktbehafteten Seite der Halbleiterbauelemente angeordnet und mit den Kontaktbereichen elektrisch verbunden.

Der Leadframe weist mindestens zwei großflächige Antennenkontakte auf, die beim Einsetzen in eine Ausnehmung im Kartenkörper oder Kartenträger mit den Kontakten der Antennenspule elektrisch verbunden werden. Die im Scheibenverband vorkonfektionierten Baugruppen werden, ggfs. nach Durchführung von elektrischen Tests, vereinzelt, so daß Leadframe-Chips vorliegen, welche als Einzelchips in die erwähnte Ausnehmung im Kartenträger eingebracht werden können.

Demnach ist eine herkömmliche Ausbildung des Moduls mit Modulträger aus Metall oder Epoxy zum Verbinden des Chips mit dem Modulträger, das Bonden und das Vergießen der Gesamtanordnung, wie beim Stand der Technik noch notwendig, nicht mehr erforderlich, wobei insbesondere die Bauhöhe, aber auch die laterale Ausdehnung der Einzelchips minimierbar ist.

Das IC-Package umfassend Substrat plus Leadframe, der gleichzeitig als Abdeckung der aktiven Seite wirkt, bildet eine direkt oberflächenmontierbare Einheit im sogenannten Chip-Size-Package-Format. Durch die Vorgabe der Außenkontaktierungsflächen, die der Verbindung mit der induktiven Signalübertragungseinrichtung oder aber auch anderen Kontaktbereichen dienen, kann auf einen separaten Modul- oder Verdrahtungsträger mit Außenkontakten verzichtet werden.

Bei einer bevorzugten Ausführungsform der Chipkarte besitzt eine für den Einsatz in den Kartenträger vorbereitete Baugruppe eine Chipfläche von im wesentlichen im Bereich von 4 bis 6 mm², wobei jeder der Kontakte zur elektrischen Verbindung mit der induktiven Signalübertragungseinrichtung etwa eine Fläche von im wesentlichen 1,75 bis 2,75 mm² aufweist, so daß die gewünschte biege- und bruchfeste, langzeitstabile elektrische Verbindung bei gleichzeitig geringer Dicke des Kartenträgers oder Kartenkörpers erreichbar ist.

Die Erfindung soll nachstehend anhand eines Ausführungsbeispieles sowie unter Zuhilfenahme von Figuren näher erläutert werden.

Hierbei zeigen:
- Fig. 1: eine Schnittdarstellung eines Ausschnittes der noch im Scheibenverband vorliegenden Halbleiterbauelemente und
- Fig. 2: eine Schnittdarstellung einer Chipkarte mit vorbereitetem, vereinzelten Transponder-Halbleiterbauelement mit Leadframekontakten.

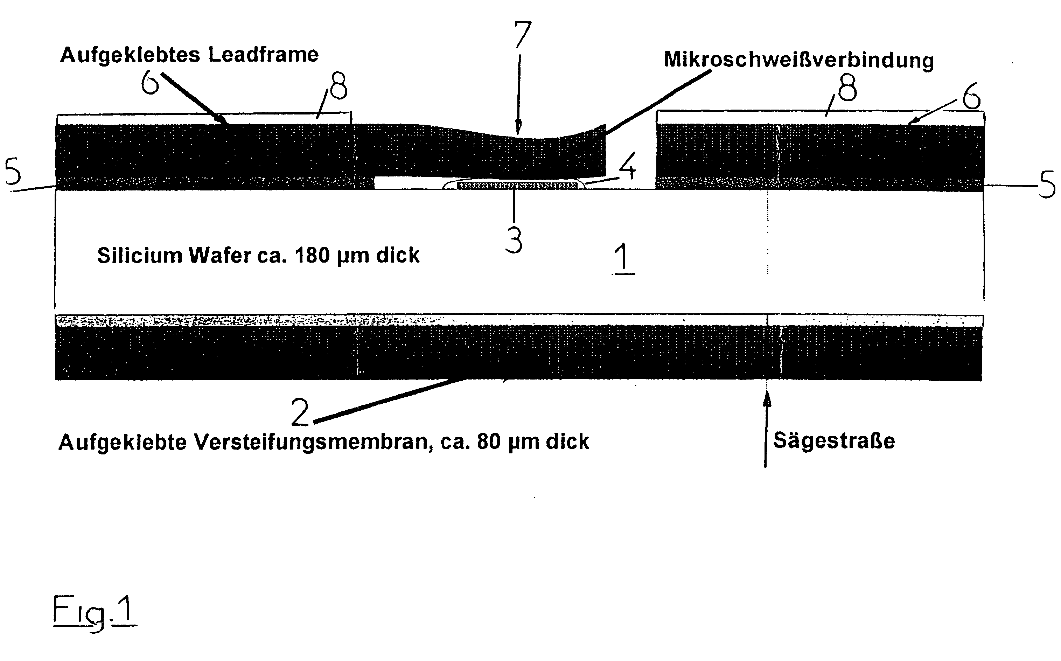

Die Fig. 1 zeigt in Schnittdarstellung den Ausschnitt eines Leadframe-Halbleiterbauelementes im Scheibenverband. Auf einem Siliziumwafer 1, welcher integrierten Strukturen z.B. einer Speicherbaugruppe enthält, wird zur Verbesserung des technologischen Handlings rückseitig eine Versteifungsmembran 2 aufgeklebt. Vor dem Aufbringen der Versteifungsmembran 2 wird allerdings der Siliziumwafer 1 auf eine Schichtdicke von ca. 180 µm, z.B. durch Ätzen, abgedünnt.

Die Bondpads 3 des Siliziumwafers 1 werden in an sich bekannter Weise mit einer schweiß- und/oder lötbaren Metallisierung 4 versehen. Anschließend wird beispielsweise mittels Siebdruckschablonen eine polymere Passivierung 5 mit Ausnahme der Bereiche der Bondpads 3 aufgebracht. Diese Passivierung schützt zum einen die aktiven Bereiche des Siliziumwafers 1 und dient zum anderen der elektrischen Isolation des dann aufzubringenden Leadframes in Wafergröße. Das in Wafergröße vorliegende Leadframe 6 wird exakt positioniert auf die aktive Seite des Siliziumwafers z.B. aufgeklebt. Anschließend erfolgt z.B. mittels Mikroschweißen eine Verbindung von entsprechenden Abschnitten 7 des Leadframes 6 mit der Metallisierungsfläche 4 der Bondpads 3. Nachdem im Scheibenverband die entsprechende elektrische Kontaktierung des Leadframes 6 mit den Bondpads 3 des Siliziumwafers 1 vorgenommen wurde, wird über vorhandene Justiermarken der vorliegende Leadframe-Wafer-Verbund in einer sogenannten Wafersäge eingerichtet und in einzelne Chip-Size-Packages entlang von Sägestraßen 9 getrennt.

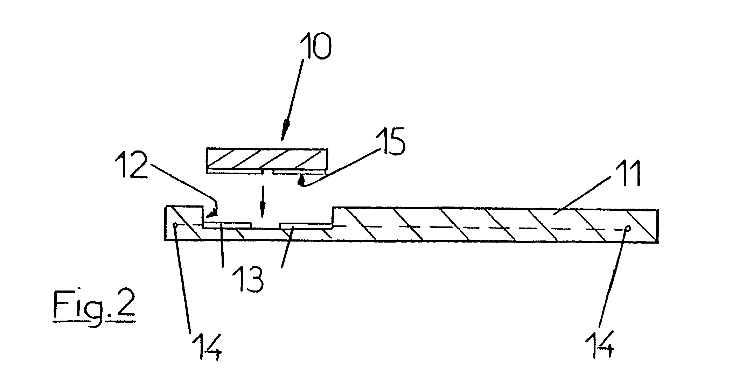

Demnach liegt im Ergebnis der vorstehend beschriebenen Schritte ein Transponder-Halbleiterbauelement vor, das unmittelbar in eine entsprechende Ausnehmung eines Kartenträgers (siehe Fig. 2) eingebracht und mit dort vorhandenen Antennenanschlußflächen elektrisch verbunden werden kann.

Die Bauhöhe des Transponder-Halbleiterbauelementes ist gering, so daß die Dicke des Kartenträgers verringert werden kann. Durch die großflächigen äußeren Anschlußkontakte 8 für die gewünschte elektrische Verbindung zur induktiven Signalübertragungseinrichtung im Kartenkörper ist eine langzeitstabile sichere elektrische und mechanische Kontaktierung gewährleistet.

Zur Aufnahme des Leadframe-Chips 10 weist, wie in Fig. 2 gezeigt, ein Kartenkörper 11 eine Ausnehmung 12 auf. Wie in der Schnittdarstellung ersichtlich, sind innerhalb der Ausnehmung 12 Antennenkontakte 13 vorgesehen, die mit einer z.B. einlaminierten Antennenspule 14 in Verbindung stehen. Die Antennenspule 14 dient als Mittel zur induktiven Signalübertragungseinrichtung hin zu einem nicht gezeigten Terminal.

Der Leadframe-Chip 10 besitzt an seiner Unterseite die bereits erwähnten Leadframe-Antennenkontakte 15 bzw. die äußeren Anschlußflächen 8. Nachdem der Leadframe-Chip 10 in die Ausnehmung 12 eingebracht wurde, kann in an sich bekannter Weise eine Kontaktierung der sich gegenüberliegenden Bereiche der Antennenkontakte 13 und der Leadframekontakte 15 vorgenommen werden. Beispielsweise besteht die Möglichkeit der Kontaktierung mittels Leitkleber, durch Thermokompression, Löt- oder Schweißverbindung.

Die Dicke der Leadframe-Chips liegt im Bereich von 180 bis 200 µm mit dem erwähnten Vorteil der geringen Bauhöhe der Gesamtanordnung der Chipkarte. Die Antennenspulen 14 können auf dem Kartenkörper in Nuten verlegte Drahtspulen sein, ebenso können jedoch gestanzte Spulen genutzt werden, die in die Karte einlaminiert werden.

Alles in allem gelingt es mit der Erfindung, Leadframe-Chips auszubilden, die kostengünstig im Scheibenverband hergestellt werden können und die die notwendige Beständigkeit bei Handhabung, Test und Montage aufweisen. Die Leadframe-Chips sind direkt oberflächenmontierbar und besitzen zwei großflächige äußere Anschlußflächen zur unmittelbaren Verbindung mit komplementär gestaltene Antennenkontakten. Die erreichte Vorverlagerung der Gehäusetechnik von der Ebene vereinzelter gesägter Chips hin zur Waferebene bzw. zum Scheibenverband führt zu erheblichen Kostenvorteilen, so daß insbesondere bei großen Stückzahlen preiswertere Chipkarten mit Transponder-Halbleiterbauelementen realisierbar sind.

### Bezugszeichenliste

- 1: Siliziumwafer
- 2: Versteifungsmembran
- 3: Bondpads
- 4: Metallisierung
- 5: Passivierung
- 6: Leadframe
- 7: Abschnitt
- 8: äußere Anschlußfläche
- 9: Sägestraße
- 10: Leadframe-Chip
- 11: Kartenkörper
- 12: Ausnehmung
- 13: Antennenkontakt
- 14: Antennenspule
- 15: Leadframe-Antennenkontakt

## Patentansprüche

1. Chipkarte mit einem Kartenkörper (11) und einem Transponder-Halbleiter Bauelemente (10), wobei dieses mit einer in dem Kartenkörper angeordneten induktiven Signalübertragungseinrichtung in Form einer Antennenspule (14) kontaktiert ist, und die Halbleiter-Bauelemente vor der Montage in den Kartenkörper (11) vereinzelte, im Scheibenverband abgedünnte Baugruppen sind,
**dadurch gekennzeichnet,**
**daß** die Baugruppen je einen Leadframe (6) auf der aktiven Seite aufweisen, wobei der Leadframe (6) zwei großflächige äußere Kontakte (8) zum Anschluß der drahtverlegten oder einlaminierten, gestanzten Antennenspule (14) umfaßt.

2. Chipkarte nach Anspruch 1,
**dadurch gekennzeichnet,**
**daß** jeder der großflächigen Kontakte (8; 15) im wesentlichen die Hälfte der maximal zur Verfügung stehenden Leadframe- oder Chipfläche einnimmt.

3. Chipkarte nach Anspruch 2,
**dadurch gekennzeichnet,**
**daß** bei einer zum Einsatz in den Kartenträger oder Kartenkörper (11) vorbereiteten Baugruppe die Chip- oder Leadframefläche im wesentlichen im Bereich von 4 bis 6 mm² einnimmt.

4. Verfahren zur Herstellung einer Chipkarte mit einem Kartenkörper und einem Transponder -Halbleiter-Bauelemente (10), welches mit einer in der Karte angeordneten induktiven Signalübertragunseinrichtung in Form einer Antennenspule (14) kontaktierbar ist,
**dadurch gekennzeichnet,**
**daß** im Scheibenverband vorliegende, Bondpads (3) umfassende, rückseitig abgedünnte Halbleiter-Bauelemente mit einer schweißund/oder lötfähigen Metallisierung (4) oder Kontaktbumps im Bereich von Bondpads versehen werden,
anschließend mit Ausnahme der Kontaktbereiche eine Passivierungsschicht (5) aufgebracht, weiterhin ein Leadframeverbund (6) in Wafergröße paßgenau je auf die aktive, kontaktbehaftete Seite der Halbleiter-Bauelemente angeordnet und mit den Kontaktbereichen elektrisch verbunden wird, wobei der Leadframeverbund jeweils Einzelleadframes mit je mindestens zwei großflächigen Antennenkontakten (8) aufweist,
die so erhaltene Baugruppe einem Vereinzeln in Leadframe-Chips unterzogen wird und diese Einzelchips in eine Ausnehmung im Kartenkörper oder Kartenträger eingebracht sowie die Leadframe-Antennenkontakte mit Kontakten der Antennenspule verbunden werden.

5. Verfahren nach Anspruch 4,
**dadurch gekennzeichnet,**
**daß** zur Verbesserung des Handlings während der Bearbeitung im Scheibenverband der abgedünnte Wafer rückseitig mit einer temporären Versteifungsmembran bzw. -schicht (2) versehen wird.

## Claims

1. A chip card with a card body (11) and a transponder semiconductor component (10) which is in contact with an inductive signal transmitting means in the form of an antenna coil (14) arranged in the card body, and wherein the semiconductor components prior to installation into the card body (11) are isolated assemblies which have been thinned in the wafer structure,
**characterised in that**
the assemblies comprise one lead frame (6) each on the active side, with the lead frame (6) including two large area outer contacts (8) for the connection of the wired or laminated punched antenna coil (14).

2. The chip card according to Claim 1,
**characterised in that**
each of the large area contacts (8; 15) essentially occupies half of the maximum available lead frame or chip surface.

3. The chip card according to Claim 2,
**characterised in that**
with an assembly prepared for the installation into the card carrier or the card body (11) the chip or lead frame surface essentially takes up an area ranging from 4 to 6 mm².

4. A method for manufacturing a chip card with a card body and a transponder semiconductor component (10) which is able to be contacted with an inductive signal transmitting means in the form of an antenna coil (14) arranged in the card body,
**characterised in that**
semiconductor components in the wafer structure, comprising bond pads (3) and having been thinned at their rear sides are provided with a metallised layer (4) capable of being welded and/or soldered or contact bumps in the area of bond pads,
subsequently a passivation layer (5) is applied with the exception of the contact areas, furthermore one lead frame compound (6) each of the wafer's size is arranged accurately fitting with the active contact-carrying side of the semiconductor components and electrically connected with the contact areas, with the lead frame compound (6) each comprising individual lead frames with at least two large area antenna contacts (8),
the assembly thus obtained is subjected to an isolation process into lead frame chips, and these individual chips are inserted into the card body or card carrier, and the lead frame antenna contacts are connected with contacts of the antenna coil.

5. The method according to Claim 4,
**characterised in that**
the thinned wafer is provided at its rear side with a temporary stiffening diaphragm or layer (2), respectively, in order to improve handling during processing in the wafer structure.

## Revendications

1. Carte à puce comprenant un corps de carte (11) et un composant à semi-conducteur (10), à savoir un transpondeur, celui-ci étant mis en contact avec un dispositif de transmission de signal inductif disposé dans le corps de carte et se présentant sous la forme d'une bobine d'antenne (14), et les composants à semi-conducteur étant des sous-ensembles séparés les uns des autres avant le montage dans le corps de carte (11), amincis sous forme d'ensemble pastille,
**caractérisée en ce que**
les sous-ensembles présentent chacun un réseau de conducteurs (6) sur leur face active, ce réseau de conducteurs (6) comprenant deux contacts extérieurs à grande surface (8) pour le raccordement des bobines d'antennes (14) estampées disposées sous forme de fils ou incorporées par stratification.

2. Carte à puce selon la revendication 1,
**caractérisée en ce que**
chacun des contacts à grande surface (8 ; 15) occupe sensiblement la moitié de la surface maximum qui est prévue pour le réseau de conducteurs ou la puce.

3. Carte à puce selon la revendication 2,
**caractérisée en ce que**
dans la cas d'un sous-ensemble préparé à être monté dans le support de carte ou dans le corps de carte (11), la surface occupée par la puce ou par le réseau de conducteurs est sensiblement comprise entre 4 et 6 mm².

4. Procédé de fabrication d'une carte à puce comprenant un corps de carte et et un composant à semi-conducteur (10), à savoir un transpondeur, qui est susceptible d'être mis en contact avec un dispositif de transmission de signal inductif disposé dans la carte et se présentant sous la forme d'une bobine d'antenne (14),
**caractérisé en ce que**
les composants à semi-conducteur amincis sur la face arrière, qui se présentent sous forme d'ensemble pastille et qui comprennent des plages de connexion (3) sont pourvus d'une métallisation (4) soudable et/ou susceptible d'être brasée ou de bossages de contact situés dans la zone des plages de connexion,
ensuite, à l'exception des zones de contact, une couche de passivation (5) est appliquée, puis un réseau de conducteurs (6) composite, de la taille d'une tranche, est disposé de façon ajustée sur la face active, équipée de contacts des composants à semi-conducteur et est raccordé électriquement aux zones de contact, le réseau de conducteurs composite présentant, à chaque fois, des réseaux de conducteurs individuels pourvus d'au moins deux contacts d'antenne à grande surface (8),
le sous-ensemble ainsi obtenu est soumis à une séparation en puces de réseaux de conducteurs et ces puces individuelles étant disposées dans un évidement ménagé dans le corps de carte ou dans le support de carte, et les contacts d'antenne des réseaux de conducteurs étant reliés aux contacts de la bobine d'antenne.

5. Procédé selon la revendication 4,
**caractérisé en ce qu'**
afin de faciliter la manipulation, lors du traitement en ensemble-pastille, la tranche amincie est temporairement revêtue, sur sa face arrière, d'une membrane ou d'une couche de rigidification (2).
